# EUROPÄISCHE PATENTSCHRIFT

(11) **EP 0 610 591 B1**
(45) Veröffentlichungstag und Bekanntmachung des Hinweises auf die Patenterteilung: **18.08.1999**
(21) Anmeldenummer: 93120706.2
(22) Anmeldetag: 23.12.1993
(51) Int. Cl.: B41F 16/00, B65H 18/28, B65H 75/24, B32B 31/00, G03F 3/10

(54) **Druck-Hilfsvorrichtung, insbesondere zur Prüfung von Druckmustern**
Printing equipment accessory, especially for making proof prints
Dispositif auxiliaire pour imprimer, notamment pour la production d'épreuves tests

(30) Priorität: 15.01.1993 DE 4300866
(43) Veröffentlichungstag der Anmeldung: 17.08.1994
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Strüwe, Volker, D-63128 Dietzenbach (DE); Wojtanowitsch, Ladislaus, D-63741 Aschaffenburg (DE); Gehrer, Gregor, A-5400 Hallein/Rehhof (AT); Brötzner, Thomas, A-5071 Wals (AT)

(56) Entgegenhaltungen:
- EP-A- 0 216 085
- EP-A- 0 435 058
- EP-A- 0 460 561
- EP-A- 0 555 928
- DE-A- 3 029 411
- DE-A- 3 800 768
- GB-A- 2 100 191
- US-A- 4 667 890

## Beschreibung

Die Erfindung betrifft eine Druck-Hilfsvorrichtung, insbesondere zur Prüfung von Druckmustern, mit mindestens zwei einen Walzenspalt bildenden Walzen, durch den eine von einer Vorratsrolle abgenommene Folie geführt ist, die einen Nutzanteil und einen Hilfsanteil aufweist, wobei der Nutzanteil im Walzenspalt auf eine Unterlage übertragbar ist.

Derartige Hilfsvorrichtungen werden beispielsweise verwendet, um Farbauszüge zu prüfen. Hierbei kann beispielsweise in einem ersten Arbeitsschritt eine sandwichartige Folie von der Vorratsrolle abgenommen werden, bei der zwischen einer Trägerschicht und einer Schutzschicht eine photopolymerisierbare Schicht angeordnet ist. Vor dem Einlaufen in den Walzenspalt wird die Schutzschicht von der polymerisierbaren Schicht abgezogen. Im Walzenspalt wird dann der verbleibende Anteil der Folie, der Nutzanteil, auf ein Trägermaterial, beispielsweise eine Papierbahn, auflaminiert. Die so mit der photopolymerisierbaren Schicht versehene Papierbahn wird dann durch ein entsprechendes Negativ oder Positiv hindurch belichtet, wodurch, je nach Ausgestaltung, die belichteten oder die unbelichteten Stellen polymerisieren, während die übrigen Bereiche klebrig bleiben. Gegebenenfalls muß noch die Trägerschicht entfernt werden. Auf die klebrigen Bereiche sollen nun Farbpartikel aufgebracht werden. Dies kann man beispielsweise mit einer Farbfolie erreichen, bei der eine Trägerschicht Farbpartikel trägt. Diese Farbfolie wird zusammen mit dem belichteten Papier wiederum durch einen Walzenspalt geführt. Der Druck im Walzenspalt bewirkt, daß die Farbpartikel an den klebrigen Bereichen festkleben und sich dann beim Trennen der Farbfolie von der Papierbahn von der Farbfolie ablösen. In diesem Fall sind die auf der Papierbahn verbliebenen Farbpartikel der Nutzanteil der Folie, während das Trägermaterial mit den verbleibenden Farbpartikeln der Hilfsanteil der Folie ist. Andere Anwendungsfälle sind das Auflaminieren von sandwichartigen Folien oder anderen Schichten wie beispielsweise Lötstopmasken und Dryfilm-Resist auf Leiterplatten zum Herstellen gedruckter Schaltungen oder das Arbeiten mit Heißschmelzklebefolien. In allen Anwendungsfällen ist der Hilfsanteil, also z.B. die Schutzfolie oder die Trägerfolie mit den verbleibenden Farbpartikeln, Abfall, der für den laufenden oder für nachfolgende Prüfvorgänge nicht mehr verwendet werden kann. Um das Volumen dieses Abfalls möglichst gering zu halten, bietet es sich an, den Hilfsanteil der Folie nach der Trennung vom Nutzanteil wieder aufzuwickeln. Hierzu wird der Anfang des Hilfsanteils mit Hilfsmitteln, z.B. einem Klebeband, mit einem Trägerkern aus Pappe oder Kunststoff verbunden. Dieser Trägerkern kann beispielsweise der Kern einer verbrauchten Vorratsrolle sein. Aus Umweltschutzgründen wird aber nicht nur eine Verringerung des Volumens des Abfalls angestrebt, sondern eine Abfallvermeidung. Hierzu versucht man, entstehenden Abfall wieder zu verwerten oder die Produkte von vornherein so anzulegen, daß sie mehrfach verwendbar sind, sogenannte Mehrweg-Produkte.

Um den Hilfsanteil der Folie wieder zu verwerten, muß man ihn vom Kern trennen, um ein sortenreines Produkt zu erhalten. Hierzu kann man beispielsweise den Hilfsanteil der Folie vom Trägerkern abwickeln, was sehr zeit- und arbeitsaufwendig ist. Deswegen wird üblicherweise der Folienwickel aufgeschnitten und der Kern entnommen. Hierbei entstehen jedoch meistens störende Flitter und zusätzlicher Schmutz. Auch wird hierdurch wieder das Volumen des Abfalls vergrößert. Die notwendige Mehrarbeit verlängert die Rüstzeiten und bringt unnötige Kosten mit sich. Der Kern wird in der Regel beim Aufschneiden beschädigt und läßt sich daher nicht mehr in einem Mehrweg-System wiederverwenden.

Aus Dokument GB-A-2100191 ist eine Druckvorrichtung bekannt bei der eine Trägerfolie von einer Rolle abgenommen, einem Walzenspalt zugeführt und eine sog. "printing layer" der Trägerfolie auf eine Bahn übertragen wird. Die "printing layer" ist ein Trockenabziehbild, ein 0,0025 bis 0,025 mm dünner "Nutzanteil" der Folie. Die Folie wird nach der Übertragung des Trockenbildes auf einer Aufnahmerolle aufgewickelt.

Aus Dokument DE 30 29 411 ist eine Wickelvorrichtung bekannt bei der eine streifenförmige Materialbahn, insbesondere eine selbstklebend ausgerüstete Schaumstoffbahn, auf einem Wickelteller, der einen Wickelkopf mit mehreren Rohrsegmenten aufweist, gewickelt wird. Der Wickelkopf arbeitet automatisch: vor dem Wickelvorgang wird er in eine Arbeitsstellung hinein und nach dem Wickelvorgang axial aus der Arbeitsebene heraus bewegt. Zu Beginn des Wickelvorgangs werden die Segmente des Wickeldorns in der Arbeitsebene gespreizt. Es entsteht eine Schlitzöffnung, die den Streifenanfang erfaßt. Nach Beendigung des Wickelvorgangs wird der Materialstreifen durchtrennt, der äußere Durchmesser der Rohrsegmente zunächst verringert und anschließend die Rohrsegmente automatisch vom Wickelteller, der in der Arbeitsebene liegt, abgesenkt. Von einer Bedienperson kann nun ein kernloser Wickel der streifenförmigen Materialbahn entnommen werden.

Der Erfindung liegt die Aufgabe zugrunde, die Verwertung zumindest des Hilfsanteils der Folie zu vereinfachen.

Diese Aufgabe wird bei einer Vorrichtung der eingangs genannten Art dadurch gelöst, daß der Hilfsanteil der Folie einen kernlosen Wickel bildet, der kernlose Wickel auf einer Wickelwelle mit veränderbarem Außendurchmesser aufgenommen ist, die Wickelwelle mindestens zwei Rohrsegmente aufweist, deren Abstand von der Wickelwellenachse veränderbar ist, daß auf der Wickelwellenachse Führungsringe vorgesehen sind, die einen Anschlag für die Bewegung der Rohrsegmente radial nach innen bilden.

Der Wickel besteht also nur noch aus dem Hilfsanteil der Folie. Er ist nicht mit anderen Materialien, beispielsweise einem Kern, durchsetzt. Er kann ohne weitere Bearbeitung der Wiederverwertung zugeführt werden. Fehler derart, daß Fremdmaterial mit in die wiederzuverwertende Charge eingetragen wird, können weitgehend vermieden werden, ohne daß zusätzliche Zeit für Kontrollen aufgebracht werden muß. Vielmehr kann durch die dargestellte Handhabung Arbeitszeit eingespart werden.

Die Kerne, die nun nicht mehr für die Erzeugung eines Wickels aus dem Hilfsanteil der Folie verwendet werden müssen, können sogar im Rahmen eines Mehrweg-Systems wiederverwendet werden.

Die kernlose Wickel ist auf einer Wickelwelle mit veränderbarem Außendurchmesser aufgenommen. Zum Wickeln wird der Außendurchmesser vergrößert. Wenn der Wickel fertiggestellt ist, wird der Durchmesser der Wickelwelle wieder verkleinert, wodurch es möglich wird, die Wickelwelle aus dem Wickel herauszuziehen. Dies erleichtert die Handhabung ganz erheblich.

Die Wickelwelle weist mindestens zwei Rohrsegmente auf, deren Abstand von der Wickelwellenachse veränderbar ist. Wird der Abstand vergrößert, vergrößert sich der Durchmesser der Wickelwelle, wird der Abstand vermindert, wird der Außendurchmesser der Wickelwelle verkleinert. Auf diese Weise läßt sich die Durchmesserveränderung sehr einfach bewirken.

Auf der Wickelwellenachse sind Führungsringe vorgesehen, die einen Anschlag für die Bewegung der Rohrsegmente radial nach innen bilden. Hierdurch wird der Außendurchmesser der Wickelwelle auf einen Minimalwert begrenzt.

Bevorzugterweise ist an mindestens einem Ende der Wickelwelle ein Konus vorgesehen, der axial in die Wickelwelle bewegbar ist. Die Schrägfläche des Konus wirkt dabei gegen die Rohrsegmente. Wird der Konus in die Wickelwelle hinein, also in Richtung zwischen die Rohrsegmente, bewegt, spreizt er die Rohrsegmente auseinander. Wird der Konus hingegen in die andere Richtung axial bewegt, läßt er eine Durchmesserverminderung der Wickelwelle zu, da die Rohrsegmente nun wieder zusammengeschoben werden können.

Auch ist von Vorteil, daß an der Innenseite der Rohrsegmente mindestens ein alle Rohrsegmente verbindender elastischer Spannring befestigt ist. Dieser Spannring hält einerseits die Rohrsegmente zusammen, so daß sie beim Einwärtsbewegen der Konen, d.h. beim Spannen, nicht herausklappen können, sondern an den Schrägflächen der Konen gehalten werden. Andererseits vermindern sie automatisch den Außendurchmesser der Wickelwelle, wenn die Konen herausbewegt werden, indem sie die Rohrsegmente so weit zusammenziehen, wie dies durch die Konen zugelassen wird.

Mit Vorteil weisen die Führungsringe Schlitze auf, in die Vorsprünge der Rohrsegmente eingreifen. Die Führungsringe begrenzen damit nicht nur die Bewegung der Rohrsegmente, sie führen sie auch. Hierdurch kann ein mechanisch stabiler Aufbau der Wickelwelle und eine Zuordnung der einzelnen Teile zueinander mit einer ausreichenden Genauigkeit gewährleistet werden. Dies gewährleistet insbesondere eine ausreichende Rundheit der Wickelwelle, die in manchen Anwendungsfallen für das Aufwickeln erforderlich ist.

Hierbei ist bevorzugt, daß die Vorsprünge stegartig ausgebildet sind. Die Rohrsegmente werden also unabhängig von der axialen Lage der Führungsringe in jedem Fall ausreichend sicher gehalten und geführt. Durch einen einfachen Austausch der Rohrsegmente kann man die wirksame Lange der Wickelwelle relativ einfach variieren.

Auch ist von Vorteil, daß der Konus Schlitze aufweist, die denen der Führungsringe entsprechen. Die Vorsprünge können also auch in den Konus eingreifen. Hierdurch werden die Rohrsegmente auch im Bereich des Konus geführt. Der Antrieb der Wickelwelle kann nun beispielsweise über den Konus erfolgen. Die Antriebsleistung kann aber auch über die Führungsringe aufgebracht werden, wenn sich die Wickelwellenachse dreht.

Bevorzugterweise sind die Führungsringe axial auf der Rohrwelle verschiebbar. Auch hiermit läßt sich eine Anpassung an unterschiedliche Längen der Rohrsegmente erzielen.

In einer weiteren bevorzugten Ausgestaltung sind auf dem Umfang der Wickelwelle Reibringe festlegbar. Mit Hilfe dieser Reibringe läßt sich die Wickelwelle antreiben. Die Reibringe bilden gleichzeitig eine axiale Begrenzung für den Wickel, so daß dieser auch in Axialrichtung kompakt bleibt, einzelne Lagen des Wickels also axial nicht verrutschen können. Die Reibringe können hierbei in verschiedenen axialen Positionen festgelegt werden, um eine Anpassung an unterschiedliche Folienbreiten zu ermöglichen.

Bevorzugterweise ist die Wickelwelle in einem vertikalen Schlitz gelagert, wobei die Reibringe auf der Vorratsrolle oder darin befestigten Antriebsringen aufliegen. Durch den vertikalen Schlitz ist es trotz einer Führung der Wickelwelle möglich, daß die Schwerkraft auf die Wickelwelle wirkt und diese nach unten drückt. Hierdurch wird die für den Antrieb notwendige Reibung zwischen den Reibringen und der Vorratsrolle oder der Antriebsringe hergestellt. Die Vorratsrolle kann dann die Wickelwelle mit antreiben, so daß bei einem Abwickeln der Vorratsrolle gleichzeitig gewährleistet ist, daß der Abfall, also der Hilfsanteil der Folie, auf die Wickelwelle aufgewickelt wird.

Bevorzugterweise weist die Wickelwelle einen Magneten auf, der gegebenenfalls zusammen mit einem Gegenstück das Ende der Folie hält. Zu Beginn des Wickelvorgangs wird also die Folie auf dem Außenumfang der Wickelwelle dadurch festgelegt, daß der Anfang der Folie im Bereich des Magneten auf die Wickelwelle gelegt und ein Gegenstück aus Eisen, beispielsweise ein dünnes Blech, auf die Folie aufgelegt wird. Die vom Magneten aufgebrachten Kräfte halten das Eisenstück an der Wickelwelle. Der Folienanfang ist dann zwischen dem Eisenstück und der Wickelwelle eingeklemmt. Der Wickelvorgang kann dann ablaufen. Am Ende, wenn die Folie von der Wickelwelle entfernt wird, wird der Durchmesser der Wickelwelle vermindert und die Wickelwelle herausgezogen. Die Klemmkraft zwischen dem Eisenstück und dem Magneten ist radial gerichtet. Sie läßt eine axiale Bewegung zwischen Magnet und Eisenstück zu. Wenn der Wickel von der Wickelwelle entfernt worden ist, fällt das Gegenstück heraus.

Die Erfindung betrifft auch ein Verfahren zum Wiederverwerten zumindest eines Teils einer aus einem Nutzanteil und einem Hilfsanteil gebildeten Folien mit folgende Schritte: Aufwickeln des Hilfsanteils als kernlosen Wickel auf einer Wickelwelle mit veränderbarem Außendurchmesser, Verringern des Außendurchmessers der Wickelwelle; Entfernen des kernlosen Wickels von der Wickelwelle; und Wiederverwerten des kernlosen Wickels.

Die Verwendung von fremden Materialien, die eine Charge von wiederzuverwertendem Hilfsanteil verunreinigen könnten, wird weitgehend vermieden.

Die Erfindung wird im folgenden anhand von bevorzugten Ausführungsbeispielen in Verbindung mit der Zeichnung beschrieben. Hierin zeigen:
- Fig. 1: eine erste Ausgestaltung,
- Fig. 2: eine zweite Ausgestaltung,
- Fig. 3: einen Längsschnitt durch eine Wickelwelle,
- Fig. 4: einen Schnitt A-A nach Fig. 3 und
- Fig. 5: einen Schnitt B-B nach Fig. 3.

Eine Druckhilfsvorrichtung 1 weist zwei Walzen 2, 3 auf, die zwischen sich einen Walzenspalt 4 ausbilden. Die beiden Walzen 2, 3 können mit gegeneinander wirkenden Kräften beaufschlagt werden, so daß unter der Wirkung des im Walzenspalt 4 herrschenden Drucks ein Nutzanteil 5 einer Folie 6 auf eine Unterlage 7 auflaminiert werden kann. Die Folie 6 weist neben dem Nutzanteil 5 auch noch einen Hilfsanteil 8 auf. Die Folie 6 ist damit sandwichartig aufgebaut. Der Nutzanteil ist im vorliegenden Fall durch eine Trägerfolie gebildet, die eine photopolymerisierbare Schicht trägt. Die photopolymerisierbare Schicht ist durch eine Schutzfolie, die den Hilfsanteil 8 bildet, abgedeckt. Die Folie 6 ist in der Zeichnung übertrieben dick dargestellt. Ihre Dicke beträgt in Wirklichkeit nur Bruchteile eines Millimeters. Die photopolymerisierbare Schicht ist aus Gründen der Übersicht nicht getrennt dargestellt. Sie ist Bestandteil des Nutzanteils 5. Die Unterlage 7 kann beispielsweise eine Papierbahn sein.

Die Folie 6 wird von einer Vorratsrolle 9 abgewickelt, die sich dabei in Richtung des Pfeiles 10 dreht. Nach dem Abwickeln der Folie 6 von der Vorratsrolle 9 wird der Hilfsanteil an einer Trennrolle 11 vom Nutzanteil getrennt. Der Nutzanteil 5 wird über eine erste Umlenkrolle 12 in Richtung auf den Walzenspalt 4 umgelenkt. Der Hilfsanteil 8 wird über eine zweite Umlenkrolle 13 zu einem Wickel 14 umgelenkt, der kernlos ausgebildet ist. Der Wickel 14 weist eine Wickelwelle 15 auf, die in einem vertikal verlaufenden Lagerschlitz 16 eines stationären Gehäuses 17 gelagert ist. In dem gleichen Lagerschlitz 16 ist auch die Vorratsrolle 9 drehbar gelagert. Der Wickel 14 liegt dabei, gegebenenfalls mit in Zusammenhang mit Fig. 3 näher dargestellten Reibringen auf der Vorratsrolle 9 auf. Wenn die Vorratsrolle 9 beim Abwickeln der Folie 6 gedreht wird, wird der Wickel 14 gleichzeitig angetrieben und wickelt den Hilfsanteil 8 der Folie 6 auf.

Nach dem Auflaminieren des Nutzanteils 5 auf die Unterlage 7 wird die so belegte Unterlage durch ein Negativ oder ein Positiv hindurch belichtet, wodurch, je nach Ausgestaltung, die belichteten oder die unbelichteten Teile des Photopolymeres polymerisieren. Nach Entfernen der Trägerfolie bleiben, wieder je nach Ausführungsform, die polymerisierten oder die nicht polymerisierten Bereiche des Photopolymeres klebrig. Auf diese Bereiche kann ein partikelförmiger Farbstoff aufgetragen werden, um diese Bereiche einzufärben.

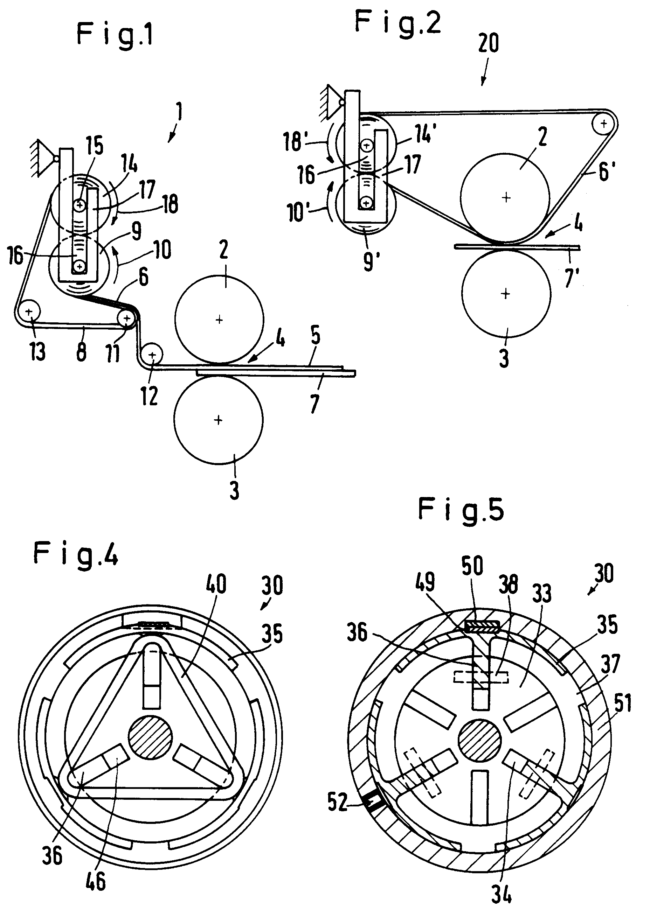

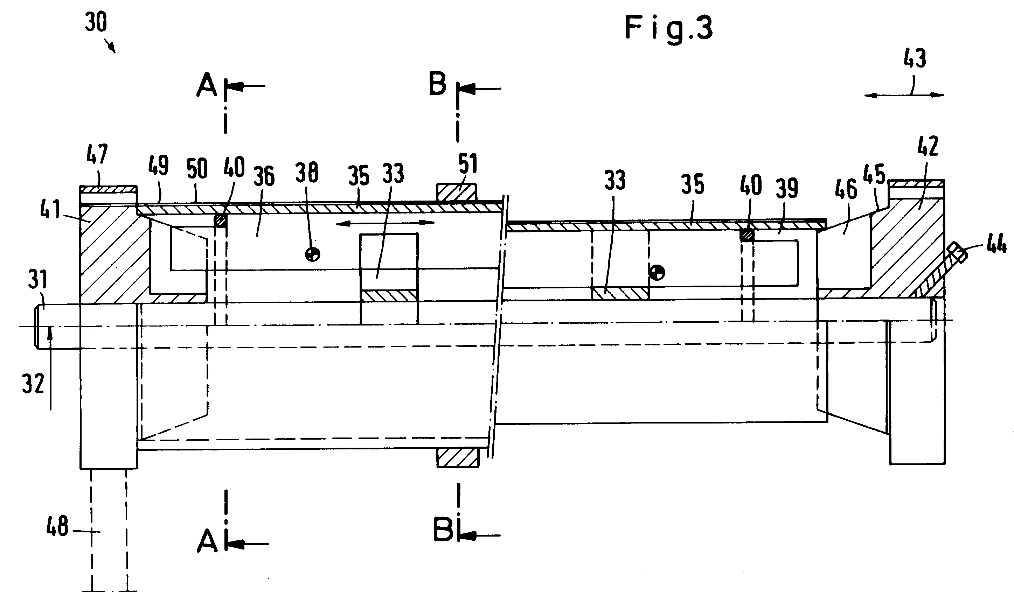

Zum Auftragen des Farbstoffs auf die so beschichtete Unterlage 7 ist eine ähnlich ausgebildete Vorrichtung 20 vorgesehen, die in Fig. 2 dargestellt ist. Teile, die denen der Fig. 1 entsprechen, sind mit gleichen Bezugszeichen versehen. Bei entsprechenden Teilen sind die Bezugszeichen zusätzlich gestrichen.

Bei der in Fig. 2 dargestellten Ausführungsform wird die gesamte Folie 6' durch den Walzenspalt 4 geführt, und zwar zusammen mit der beispielsweise mit der Vorrichtung 1 nach Fig. 1 beschichteten Unterlage 7, die hier mit 7' bezeichnet ist. Die Folie 6' besteht aus einem Trägermaterial, das Farbpartikel trägt. Das Trägermaterial ist der Hilfsanteil. Die Farbpartikel sind der Nutzanteil dieser Folie 6'. Wird nun die Unterlage 7' zusammen mit der Folie 6' durch den Walzenspalt 4 geführt, bewirkt der im Walzenspalt 4 herrschende Druck der beiden Walzen 2, 3, daß die Farbpartikel an der Unterlage 7' im Bereich der klebrigen Stellen auf die Unterlage 7' übertragen werden und dort haften bleiben. Die aus dem Walzenspalt 4 herauskommende Folie 6' ist dann Abfall und wird auf dem Wickel 14' aufgewickelt. Auch der Wickel 14' ist kernlos ausgebildet.

Dargestellt ist auch hier wieder der Antrieb des Wickkels 14' durch die Vorratsrolle 9'. Es ist aber leicht einzusehen, daß der Wickel 14' auch auf jede andere Art und Weise angetrieben werden kann, beispielsweise durch einen eigenen Motor oder über ein Getriebe von einem gemeinsam für den Wickel 14' und die Vorratsrolle 9' bzw. die Walzen 2, 3 vorgesehenen Motor.

Wenn die Vorratsrollen 9 oder 9' vollständig abgewickelt sind, ist ein Wickel 14, 14' entstanden, der den gesamten Hilfsanteil der Folien 6, 6' aufgewickelt hat, wobei kein Kern in dem Wickel 14, 14' zu finden ist. Der gesamte Wickel 14, 14' kann also einer Wiederverwertung zugeführt werden. Zum Aufwickeln des Wickels 14, 14' dient eine Wickelwelle 30, die in den Fig. 3 bis 5 näher dargestellt ist. Die Wickelwelle 30 hat einen veränderbaren Außendurchmesser. In Fig. 3 ist auf der linken Seite der Betriebszustand der Wickelwelle 30 dargestellt, in der der Außendurchmesser seinen maximalen Wert angenommen hat. An der rechten Seite ist der Zustand dargestellt, in dem der Außendurchmesser seinen minimalen Wert angenommen hat.

Die Wickelwelle 30 weist eine Wickelwellenachse 31 auf, die in nur schematisch dargestellten Lagerungen 32 gelagert ist. Die Lagerung 32 kann die Wickelwellenachse 31 in bekannter Weise schalenförmig, punktförmig oder kreisförmig umschließen. Die Lagerstelle kann als Gleit- oder als Kugellager ausgebildet sein. Die Wickelwelle ist zweckmäßigerweise an beiden Enden gelagert.

Auf der Wickelwellenachse 31 sind axial verschiebbar mehrere, im vorliegenden Ausführungsbeispiel zwei, geschlitzte Führungsringe 33 axial verschiebbar angeordnet. Ihre Schlitze 34 verlaufen in Radialrichtung. Die Führungsringe 33 dienen, wie dies aus der rechten Hälfte von Fig. 3 ersichtlich ist, als Anschlag für eine radiale Einwärtsbewegung von Rohrsegmenten 35, die stegartig ausgebildete, radial nach innen weisende Vorsprünge 36 aufweisen. Diese Vorsprünge 36 sind in den Schlitzen 34 der Führungsringe 33 geführt. Die Rohrsegmente 35 können aus gezogenem Material gebildet sein. Ihr Außenumfang hat die Form einer Teilzylinderfläche. Mehrere Rohrsegmente 35 zusammen bilden praktisch einen Zylinder, dessen Mantelfläche lediglich durch Lücken 37 unterbrochen ist. Die Lücken 37 haben jedoch keinen nennenswerten Einfluß auf die Rundheit eines Wickels.

In den Vorsprüngen 36 sind Anschlagstifte 38 angeordnet, die die axiale Bewegung der Führungsringe 33 begrenzen.

Die Vorsprünge 36 weisen stirnseitig Ausnehmungen 39 auf, in denen elastische Endlosspannringe 40 angeordnet sind. Die Spannringe haben eine leichte Vorspannung und halten die einzelne Rohrsegmente 35 mit ihren Vorsprüngen 36 in den Schlitzen 34 der Führungsringe 33. Auf der Wickelwellenachse 31 sind zwei Spannkonen 41, 42 angeordnet, von denen der eine 41 ortsfest auf der Wickelwellenachse 31 ist, während der andere in Richtung des Doppelpfeiles 43 axial verschiebbar und mit einer Klemmschraube 44 auf der Wickelwellenachse 31 axial festlegbar ist. Natürlich können auch beide Spannkonen 41, 42 axial verschiebbar sein. Sie müssen jedoch in mindestens einer vorbestimmten Stellung auf der Wickelwellenachse 31 festlegbar sein.

Wenn die beiden Spannkonen 41, 42 auf einander zu verschoben werden, tritt ein Spannen der Wickelwelle 30 ein, d.h. eine Durchmesservergrößerung. Die Rohrsegmente 35 gleiten dabei auf den Schrägflächen 45 der Konen 41, 42 radial nach außen. Zu überwinden ist hier lediglich die von den Spannringen 40 aufgebrachte Kraft. Werden die Spannkonen 41, 42 voneinander wegbewegt, ziehen die Spannringe 40 die Rohrsegmente 35 radial zusammen, so daß eine Durchmesserverringerung eintritt. Diese ist in der rechten Hälfte der Fig. 3 dargestellt.

Auch die Spannkonen 41, 42 weisen Schlitze 46 auf, die den Schlitzen 34 der Führungsringe 33 entsprechen. In diese Schlitze 46 können die Vorsprünge 36 der Rohrsegmente 35 eintreten, wenn die Spannkonen 41, 42 auf einander zu bewegt werden.

Die Spannkonen 41, 42 tragen Reibringe 47, mit deren Hilfe sie durch eine Treibscheibe 48 angetrieben werden können. Die Treibscheibe 48 kann, muß aber nicht, an der Vorratsrolle 9 befestigt sein. Sie kann aber auch unbahängig davon angetrieben werden, so daß die Wickelwelle 30 den aufzuwickelnden Hilfsanteil der Folie 6 permanent unter Spannung hält.

Zusätzlich können weitere Reibringe 51 vorgesehen sein, die auf dem Außenumfang der Rohrsegmente 35 in verschiedenen axialen Positionen festgelegt werden können. In vielen Fällen werden die Reibringe 51 bereits durch die Durchmesservergrößerung der Wickelwelle 30 bzw. Auseinanderbewegen der Rohrsegmente 35 ausreichend festgehalten und gegen axiale Verschiebung durch die dabei entstehenden Klemmkräfte gesichert. Mann kann jedoch zusätzlich eine Madenschraube 52 vorsehen, die in den Reibring 51 hineingeschraubt ist und auf ein Rohrsegment 35 drückt. Anstelle der Madenschraube 52 können ein oder mehrere Paßstifte, die in entsprechenden Bohrungen der Rohrsegmente und Reibringe 51 stecken, verwendet werden. Mit Hilfe der Reibringe 51 läßt sich eine Anpassung der Wickelwelle 30 an unterschiedliche Bahnbreiten erzielen, ohne die Rohrsegmente 35 austauschen zu müssen.

An mindestens einem Rohrsegment 35 ist eine kleine Nut eingearbeitet, in der ein Magnetband 49, also ein bandförmig ausgestalteter Magnet, angeordnet ist. Auf das Magnetband 49 kann ein Gegenstück 50, beispielsweise aus Eisenblech, aufgelegt werden. Das Gegenstück 50 wird durch das Magnetband 49 an dem Rohrsegment 35 gehalten.

Vor Beginn des eigentlichen Wickelvorgangs wird die Wickelwelle gespannt, d.h. die Konen 41, 42 werden auf einander zu bewegt und dann, wenn die Wickelwelle 30 ihren größten Außendurchmesser angenommen hat, auf der Wickelwellenachse 31 festgelegt. Der Hilfsanteil der Folie 6, 6', der aufgewickelt werden soll, wird nun mit seinem Anfang auf das Magnetband 49 gelegt. Das Gegenstück 50 wird aufgelegt und klemmt die Folie bzw. den Hilfsanteil davon an der Wickelwelle 30 fest. Die Kraft ist hierbei nicht übermäßig groß. Sie reicht aber aus, um den Anfang der Folie an der Wickelwelle 30 zu fixieren. Oft reicht es auch aus, die Folie an der Wickelwelle anzulegen und dort glattzustreichen. Insbesondere bei sehr dünnen Folien reicht die Adhäsion aus, um den Wickelvorgang anlaufen zu lassen. Sobald eine oder mehrere Lagen der Folien aufgewickelt sind, hält die Folie ohnehin selbsttätig an der Wickelwelle 30.

Wenn der Wickel 14, 14' fertiggestellt ist, wird die Wickelwelle 30 mit dem Wickel 14, 14' aus der Vorrichtung 1, 20 entfernt und die Wickelwelle 30 entspannt, d.h. die Spannkonen 41, 42 werden voneinander entfernt, wodurch sich der Außendurchmesser der Wickelwelle 30 ganz drastisch vermindert. Die gesamte Wickelwelle 30 kann nun aus dem Wickel 14, 14' axial herausgezogen werden. Der Aufbau des Wickels 14, 14' bleibt im übrigen unverändert. Das Gegenstück 50 wird hierbei vom Magnetband 49 abgezogen und fällt nach dem Herausziehen der Wickelwelle 30 aus dem Wickel 14, 14' heraus.

## Patentansprüche

1. Druck-Hilfsvorrichtung, insbesondere zur Prüfung von Druckmustern, mit mindestens zwei einen Walzenspalt bildenden Walzen, durch die zumindest ein Nutzanteil einer von einer Vorratsrolle abgenommenen Folie geführt ist, die neben dem Nutzanteil einen Hilfsanteil aufweist, wobei der Nutzanteil im Walzenspalt auf eine Unterlage übertragbar ist,
dadurch gekennzeichnet, daß,
der Hilfsanteil (8) der Folie (6,6') einen kernlosen Wickel (14, 14') bildet,
der kernlose Wickel (14, 14') auf einer Wickelwelle (30) mit veränderbarem Außendurchmesser aufgenommen ist,
die Wickelwelle (30) mindestens zwei Rohrsegmente (35) aufweist, deren Abstand von der Wickelwellenachse (31) veränderbar ist,
daß auf der Wickelwellenachse (31) Führungsringe (33) vorgesehen sind, die einen Anschlag für die Bewegung der Rohrsegmente (35) radial nach innen bilden.

2. Vorrichtung nach Anspruch 1, dadurch gekennzeichnet, daß an mindestens einem Ende der Wickelwelle (30) ein Konus (41, 42) vorgesehen ist, der axial in die Wickelwelle (30) bewegbar ist.

3. Vorrichtung nach Anspruch 1 oder 2, dadurch gekennzeichnet, daß an der Innenseite der Rohrsegmente (35) mindestens ein alle Rohrsegmente (35) verbindender elastischer Spannring (40) befestigt ist.

4. Vorrichtung nach Anspruch 1, dadurch gekennzeichnet, daß die Führungsringe (33) Schlitze (34) aufweisen, in die Vorsprünge (36) der Rohrsegmente (35) eingreifen.

5. Vorrichtung nach Anspruch 4, dadurch gekennzeichnet, daß die Vorsprünge (36) stegartig ausgebildet sind.

6. Vorrichtung nach Anspruch 4 oder 5, dadurch gekennzeichnet, daß der Konus (41, 42) Schlitze (46) aufweist, die denen der Führungsringe (33) entsprechen.

7. Vorrichtung nach einem der Ansprüche 1 bis 6, dadurch gekennzeichnet, daß die Führungsringe (33) axial auf der Wickelwellenachse verschiebbar sind.

8. Vorrichtung nach einem der Ansprüche 1 bis 7, dadurch gekennzeichnet, daß auf dem Umfang der Wickelwelle (30) Reibringe (47, 51) festlegbar sind.

9. Vorrichtung nach Anspruch 8, dadurch gekennzeichnet, daß die Wickelwelle (30) in einem vertikalen Schlitz (16) gelagert ist, wobei die Reibringe (47, 51) auf der Vorratsrolle (9, 9') oder daran befestigten Antriebsringen aufliegen.

10. Vorrichtung nach einem der Ansprüche 1 bis 9, dadurch gekennzeichnet, daß die Wickelwelle (30) einen Magnet (49) aufweist, der gegebenenfalls zusammen mit einem Gegenstück (50) das Ende der Folie hält.

11. Verfahren zum Wiederverwerten zumindest eines Teils einer aus einem Nutzanteil und einem Hilfsanteil gebildeten Folie mit folgenden Schritten:
Aufwickeln des Hilfsanteils als kernlosen Wickel auf einer Wickelwelle mit veränderbarem Außendurchmesser;
Verringern des Außendurchmessers der Wickelwelle;
Entfernen des kernlosen Wickels von der Wickelwelle; und
Wiederverwerten des kernlosen Wickels.

## Claims

1. Printing equipment accessory, in particular for making proof prints, having at least two rolls which form a nip and through which at least a useful component of a film that is taken off a supply roll is guided, the said film having an auxiliary component as well as a useful component, it being possible for the useful component to be transferred in the nip to a substrate,
characterized in that
the auxiliary component (8) of the film (6, 6') forms a centreless coil (14, 14'),
the centreless coil (14, 14') is accommodated on a winder shaft (30) whose outside diameter can be varied,
the winder shaft (30) has at least two tube segments (35), whose distance from the winder-shaft axle (31) can be varied,
and in that guide rings (33), which form a stop for the radially inward movement of the tube segments (35), are provided on the winder-shaft axle (31).

2. Accessory according to Claim 1, characterized in that a cone (41, 42), which can be moved axially into the winder shaft (30), is provided at at least one end of the winder shaft (30).

3. Accessory according to Claim 1 or 2, characterized in that at least one elastic clamping ring (40), which connects all the tube segments (35), is fastened to the inside of the tube segments (35).

4. Accessory according to Claim 1, characterized in that the guide rings (33) have slots (34), in which projections (36) from the tube segments (35) engage.

5. Accessory according to Claim 4, characterized in that the projections (36) are of web-like design.

6. Accessory according to Claim 4 or 5, characterized in that the cone (41, 42) has slots (46), which correspond to those in the guide rings (33).

7. Accessory according to one of Claims 1 to 6, characterized in that the guide rings (33) can be displaced axially on the winder-shaft axle.

8. Accessory according to one of Claims 1 to 7, characterized in that friction rings (47, 51) can be fixed on the circumference of the winder shaft (30).

9. Accessory according to Claim 8, characterized in that the winder shaft (30) is mounted in a vertical slot (16), the friction rings (47, 51) resting on the supply roll (9, 9') or drive rings fastened thereto.

10. Accessory according to one of Claims 1 to 9, characterized in that the winder shaft (30) has a magnet (49), which, if necessary, together with a mating piece (50), holds the end of the film.

11. Method of recycling at least part of a film formed from a useful component and an auxiliary component, having the following steps:
winding up the auxiliary component as a centreless coil on a winder shaft whose outer diameter can be varied;
reducing the outer diameter of the winder shaft;
removing the centreless coil from the winder shaft; and
recycling the centreless coil.

## Revendications

1. Dispositif auxiliaire d'impression, en particulier pour réaliser des épreuves d'impression d'essai, comprenant au moins deux cylindres formant un intervalle entre cylindres, à travers lequel est guidée au moins une partie utile d'une feuille prise dans un rouleau de réserve, ladite feuille présentant à côté de la partie utile une partie auxiliaire, la partie utile étant susceptible d'être transmise dans l'intervalle entre cylindres sur un support, caractérisé en ce que
la partie auxiliaire (8) de la feuille (6, 6') forme un enroulement sans noyau (14, 14'), l'enroulement sans noyau (14, 14') est tenu sur un arbre d'enroulement (30) dont le diamètre extérieur est susceptible de varier, l'arbre d'enroulement (30) comporte au moins deux segments annulaires (35) dont la distance de l'axe (31) d'arbre d'enroulement est susceptible d'être modifiée, et en ce que des bagues de guidage (33) sont prévues sur l'axe (31) de l'arbre d'enroulement, et forment une butée pour délimiter radialement vers l'intérieur le déplacement des segments annulaires (35).

2. Dispositif selon la revendication 1, caractérisé en ce qu'à au moins une extrémité de l'arbre d'enroulement (30) est prévu un cône (41, 42) qui est susceptible de se déplacer axialement dans l'arbre d'enroulement (30).

3. Dispositif selon la revendication 1 ou 2, caractérisé en ce que, sur la face intérieure des segments annulaires (35), est fixée au moins une bague élastique de serrage (40) reliant tous les segments annulaires (35).

4. Dispositif selon la revendication 1, caractérisé en ce que les bagues de guidage (33) comportent des fentes (34), dans laquelle s'engagent les parties en saillie (36) des segments annulaires (35).

5. Dispositif selon la revendication 4, caractérisé en ce que les parties en saillie (36) sont réalisées sous la forme de barrettes.

6. Dispositif selon la revendication 4 ou 5, caractérisé en ce que le cône (41, 42) comporte des fentes (46), qui correspondent à celles des bagues de guidage (33).

7. Dispositif selon l'une des revendications 1 à 6, caractérisé en ce que les bagues de guidage (33) sont susceptibles de coulisser axialement sur l'axe de l'arbre d'enroulement.

8. Dispositif selon l'une des revendications 1 à 7, caractérisé en ce que des bagues de friction (47, 51) sont susceptibles d'être fixées sur la périphérie de l'arbre d'enroulement (30).

9. Dispositif selon la revendication 8, caractérisé en ce que l'arbre d'enroulement (30) est monté à rotation dans une fente verticale (7), les bagues de friction (47, 51) étant appuyées sur le rouleau de réserve (9, 9') ou sur des bagues d'entraînement fixées à ce rouleau.

10. Dispositif selon l'une des revendications 1 à 9, caractérisé en ce que l'arbre d'enroulement (30) comporte un aimant (49) qui, le cas échéant avec une contre-pièce (50), retient l'extrémité de la feuille.

11. Procédé pour rendre réutilisable au moins une partie d'une feuille formée d'une partie utile et d'une partie auxiliaire, le procédé présentant les étapes suivantes consistant :
à enrouler la partie utile sous la forme d'un enroulement sans noyau sur un arbre d'enroulement présentant un diamètre extérieur susceptible de varier ;
à réduire le diamètre extérieur de l'arbre d'enroulement ;
extraire l'enroulement sans noyau de l'arbre d'enroulement ; et
réutiliser l'enroulement sans noyau.
